# EUROPÄISCHE PATENTSCHRIFT

(11) **EP 2 144 300 B1**
(45) Veröffentlichungstag und Bekanntmachung des Hinweises auf die Patenterteilung: **08.08.2018**
(21) Anmeldenummer: 09162975.8
(22) Anmeldetag: 17.06.2009
(51) Int. Cl.: F24S 25/00

(54) **Rahmen für ein plattenförmiges Solarelement**
Framework for a plate-shaped solar element
Cadre pour un élément solaire en forme de plaques

(30) Priorität: 07.07.2008 DE 102008031545
(43) Veröffentlichungstag der Anmeldung: 13.01.2010
(73) Patentinhaber: tesa SE, 22848 Norderstedt (DE)
(72) Erfinder: Schwertfeger, Michael, 22147 Hamburg (DE); Gassner, Thomas, 25436 Heidgraben (DE)

(56) Entgegenhaltungen:
- EP-A1- 1 009 037
- EP-A2- 1 548 846
- DE-A1- 3 611 545
- DE-U1- 20 209 218
- JP-A- 2000 226 909
- JP-A- 2006 132 111

## Beschreibung

Die Erfindung betrifft einen Rahmen für ein plattenförmiges Solarelement sowie die Verwendung eines derartigen Rahmens für die Herstellung eines Solarmoduls.

Solarmodule bestehen aus einem Rahmen, der das Solarelement, das in der Regel eine Vielzahl von Solarzellen, die in einer Ebene angeordnet und in einer Kunststofffolie eingebettet sind, umfasst. Die Kunststofffolie ist in der Regel von einer Glassplatte bedeckt und weist eine Rückseitenkaschierung auf, die üblicherweise ebenfalls aus Kunststoff besteht. Das Solarelement, das gelegentlich auch als rahmenloses Solarmodul oder Laminat bezeichnet wird, ist von einem Rahmen eingefasst, der eine Versteifung des Solarelementes bewirkt, das Solarelement, insbesondere die Glasscheibe, während des Transportes schützt, und eine Befestigung von Solarelementen auf bauliche Einrichtungen ermöglicht. Das gerahmte Solarelement wird in der Regel als Solarmodul bezeichnet.

Nach dem Stand der Technik werden in der Regel einteilige Rahmen verwendet. Ein solcher Rahmen wird seitlich auf die Außenkanten des Solarelementes gedrückt. Anschließend werden die Kanten des Solarmoduls manuell verklebt. Diese Verfahrensweise ist wenig effizient.

Ferner sind zweiteilige Rahmen bekannt, die ein unteres Rahmenelement umfassen, auf den das Solarelement aufgelegt wird. Der eigentliche Rahmen wird erhalten, indem ein oberes Rahmenelement in das untere Rahmenelement unter Erhalt einer kraft- oder formschlüssigen Verbindung eingepresst wird, wobei zwischen dem unteren und dem oberen Rahmenelement ein Spalt ausgebildet wird, in den Randbereich des Solarelementes eingeführt wird.

DE 202 09 218 U1 offenbart einen zweitteiligen Rahmen für ein rahmenloses Solarmodul, der ein unteres Rahmenelement mit einer Fläche umfasst, auf die das Solarmodul aufgelegt wird. Ferner ist in dem unteren Rahmenelement ein Schlitz vorgesehen, in den ein Schenkel eines oberen, winkelförmigen Rahmenelementes eingefügt wird, wodurch eine form- und/oder kraftschlüssige Verbindung zwischen den beiden Rahmenelementen erhalten wird. Bevor das Solarmodul in den Rahmen eingelegt wird, wird der Randbereich des Solarmoduls in ein elastisches Material, beispielsweise eine Dichtung eingehüllt, die nach der Montage zwischen dem Rahmen und Solarmodul angeordnet ist. Die Fertigung eines solchen Rahmens sowie die Anbringung der Dichtung sind jedoch aufwendig.

Gemäß DE 202 09 218 U1 ist als Befestigung für ein Laminat in einem Grundrahmen vorgesehen, dass der Grundrahmen im Bereich der Aufnahme für das Laminat eine in das Rahmeninnere offene winkelprofilartige Ausnehmung aufweist, so dass das eingelegte Laminat sich auf der unteren Fläche abstützt und seitlich von der anderen Fläche der Ausnehmung unter Wahrung eines Schlitzes zum Laminat umrahmt ist, wobei in den Schlitz eine Deckleiste unter Bildung einer form- und/oder kraftschlüssigen Verbindung mit der das Laminat umrahmenden Fläche und dem Laminat einlegbar ist.

Aufgabe der Erfindung ist es, die Nachteile nach dem Stand der Technik zu beseitigen. Es soll insbesondere ein Rahmen zur Aufnahme eines plattenförmigen Solarelementes angegeben werden, der eine effizientere und kostengünstigere Rahmung von Solarelementen ermöglicht.

Diese Aufgabe wird durch die Merkmale der Ansprüche 1 und 12 gelöst. Zweckmäßige Ausgestaltungen der Erfindung ergeben sich aus den Merkmalen der Ansprüche 2 bis 11 und 13.

Nach Maßgabe der Erfindung ist ein Rahmen für ein plattenförmiges Solarelement vorgesehen, der ein unteres Rahmenelement (21) mit einer ersten Fläche (24) und ein oberes Rahmenelement (11) mit einer zweiten Fläche (14) umfasst, wobei die zweite Fläche (14) der ersten Fläche (24) gegenüberliegt und von dieser unter Ausbildung einer Spaltes beabstandet ist, der den Randbereich des plattenförmigen Solarelementes (31) aufnehmen kann, wobei die erste Fläche und die zweite Fläche jeweils selbstklebend ausgerüstet sind, wobei der Rahmen dadurch gekennzeichnet ist, dass das untere Rahmenelement (21) eine Ausnehmung (26) aufweist, die an der Rahmenaußenseite und orthogonal zur ersten Fläche (24) ausgebildet ist, und das obere Rahmenelement (11) einen Schenkel (15) aufweist, der in die Ausnehmung (26) unter Erhalt einer form- und/oder kraftschlüssigen Verbindung eingeführt werden kann, wobei der Schenkel (15) orthogonal zur zweiten Fläche (14) des oberen Rahmenelementes (11) ausgebildet ist und sich von dieser in Richtung des unteren Rahmenelementes (21) erstreckt. Vorzugsweise ist dabei die erste Fläche mit einem ersten Klebeband und die zweite Fläche mit einem zweiten Klebeband ausgerüstet.

Das erste und das zweite Klebeband sind zweckmäßigerweise doppelseitige Klebebänder, vorzugsweise doppelseitige Schaumklebebänder. Dabei weist das doppelseitige Klebeband, mit dem die erste Fläche ausgerüstet ist (erstes doppelseitiges Klebeband), eine innere Kleberschicht auf, die in Kontakt mit der ersten Fläche steht, während die äußere Kleberschicht der zweiten Fläche des oberen Rahmenelementes zugewandt ist. Das doppelseitige Klebeband, mit dem die zweite Fläche ausgerüstet ist (zweites doppelseitiges Klebeband), weist ebenfalls eine innere Kleberschicht auf, die in Kontakt mit der zweiten Fläche steht, während die äußere Kleberschicht der ersten Fläche des unteren Rahmenelementes zugewandt ist.

Das erste und das zweite Rahmenelement können aus demselben oder unterschiedlichen Materialien bestehen. Nach einer bevorzugten Ausführungsform bestehen das untere und das obere Rahmenelement aus einem witterungsbeständigen Material, wie beispielsweise Aluminium, oder anderen geeigneten Materialien.

Unter einem Solarelement wird hier das Laminat, das die Solarzellen umfasst, verstanden. Das Solarelement ist rahmenlos. Unter einem Solarmodul wird hier das gerahmte Solarelement, also das Solarelement, das in den Rahmen eingesetzt ist, verstanden.

Der erfindungsgemäße, zweiteilige Rahmen ermöglicht aufgrund der Ausrüstung der beiden Flächen, die in Kontakt mit dem Randbereich des plattenförmigen Solarelementes gelangen, den Verzicht einerseits auf eine Dichtung und andererseits auf eine manuelle Verklebung. Damit entfallen aufwendige und unhandliche Verklebungsprozesse direkt auf dem Solarmodul vollständig, was die Montage des Solarelementes in einen Rahmen erheblich vereinfacht. Die beiden Klebebänder übernehmen zusätzlich zur Abdichtung des Solarmoduls gegen Witterungseinflüsse die Funktion der Verbindung zwischen oberem und unterem Rahmenelement, wobei der klebende Kraftschluss über das Solarelement entsteht. Außerdem können die beiden Rahmenelemente durch eine optionale form- und/oder kraftschlüssige Verbindung zusätzlich miteinander verbunden werden. Der Montage-Vorgang wird durch den erfindungsgemäßen Rahmen so vereinfacht, dass neben der aktuell üblichen Montage innerhalb der Produktionshallen nun auch sogar eine Montage vor Ort denkbar ist. Dabei wird zuerst das untere Rahmenelement am Bestimmungsort fest montiert und danach das Solarelement und das obere Rahmenelement wie nachstehend beschrieben zusammengesetzt.

Die beiden Rahmenelemente werden bereits während ihrer Herstellung mit dem Klebeband ausgerüstet, wobei die Oberfläche der ersten und der zweiten Kleberschicht, die sich nicht in Kontakt mit der ersten bzw. zweiten Fläche befindet, mit jeweils einer Abdeckung versehen ist. Diese Abdeckungen werden erst bei der Montage des Solarmoduls entfernt.

Zur Herstellung des Solarmoduls wird zunächst die Abdeckung von der Kleberschicht entfernt, die sich auf der ersten Fläche des unteren Rahmenelementes befindet. Dann wird die Unterseite des plattenförmigen Solarelementes in dessen Randbereich auf die Kleberschicht, die sich auf der ersten Fläche des unteren Rahmenelementes befindet, aufgelegt, wodurch eine Klebeverbindung zwischen dem unteren Rahmenelement und der Solarelemente ausgebildet wird. Anschließend wird das obere Rahmenelement derart auf das plattenförmige Solarelement aufgebracht, dass die Kleberschicht, die sich auf der zweiten Fläche des oberen Rahmenelementes befindet und von der zuvor die Abdeckung entfernt worden ist, in Kontakt mit der Oberseite des plattenförmigen Solarelementes in dessen Randbereich gelangt. Dabei wird eine Klebeverbindung zwischen dem oberen Rahmenelement und dem Solarelement ausgebildet.

Ist das plattenförmige Solarelement in den Rahmen eingelegt, so befindet sich die Unterseite des plattenförmiges Solarelementes in dessen Randbereich in Kontakt mit der Kleberschicht des ersten Klebebandes und die Oberseite des Solarmoduls in dessen Randbereich in Kontakt mit der Kleberschicht des zweiten Klebebandes.

Vorzugsweise weist das untere Rahmenelement eine Anschlagkante für das plattenförmige Solarelement auf, die sich von der ersten Fläche in Richtung der zweiten Fläche erstreckt und den Spalt, der zwischen der ersten Fläche und der zweiten Fläche ausgebildet ist, nach außen hin begrenzt. Die Anschlagkante ermöglicht eine genaue Positionierung des Solarelementes auf der zweiten Oberfläche.

Ferner weist das untere Rahmenelement eine Ausnehmung, die an der Rahmenaußenseite und orthogonal zur erste Fläche ausgebildet ist, und das obere Rahmenelement einen Schenkel auf, der in die Ausnehmung unter Erhalt einer form- und oder kraftschlüssigen Verbindung eingeführt werden kann, wobei der Schenkel orthogonal zur zweiten Fläche des oberen Rahmenelementes ausgebildet ist und sich von dieser in Richtung des unteren Rahmenelementes erstreckt. Auf diese Weise wird eine glatte Außenkante des Rahmens erreicht.

Zweckmäßigerweise sind sowohl das untere Rahmenelement als auch das obere Rahmenelement jeweils aus Teilelementen zusammengesetzt, wobei die Teilelemente mittels Verbindungselementen miteinander verbunden sind. Typischerweise ist das plattenförmige Solarelement rechteckig, so dass das untere und das obere Rahmenelement jeweils aus vier Teilelementen zusammengesetzt ist, wobei benachbarte Teilelemente des jeweiligen Rahmenelementes rechtwinklig zueinander angeordnet sind. Die Teilelemente sind vorzugsweise Profilelemente, die Profilhohlräume aufweisen. Zur Verbindung benachbarter Teilelemente sind Verbindungselemente, beispielsweise handelsübliche Eckverbindungen, vorgesehen, die formschlüssig in die Profilhohlräume eingesteckt werden können. Die Kontur der ersten Fläche des unteren Rahmenelementes und die Kontur der zweiten Fläche des oberen Rahmenelementes entsprechen somit dem Randbereich des Solarelementes. Die Profilelemente sind bevorzugt vorkonfektionierte, auf Gehrung und vorgegebene Länge geschnittene Profilelemente, so dass eine Montage des Rahmens sehr einfach möglich ist. Ferner sind sämtliche notwendigen Bohrungen, wie sie beispielsweise zur Montage eines Solarmoduls auf baulichen Anlagen benötigt werden, in die beiden Rahmenelemente bereits eingebracht. Die Aufbringung der selbstklebenden Ausrüstung, insbesondere der beiden Klebebänder kann in einem automatisierten Verfahren erfolgen.

Zur Abführung von Wasser kann zwischen dem unteren Rahmenelement und dem oberen Rahmenelement ein Drainagekanal ausgebildet sein. Vorzugsweise ist die Unterseite des Drainagekanals von einer Rille gebildet, die in einem Bereich der ersten Fläche des unteren Rahmenelementes ausgebildet ist, der nicht von dem ersten doppelseitigen Klebeband bedeckt ist und von diesem in Richtung der Rahmenaußenkante beabstandet ist. Der Drainagekanal hat zwei wesentliche Funktionen: zum einen den Ausgleich von unterschiedlichen Ausdehnungen der Bauteile bei schwankenden Temperaturen und zum anderen die Abführung von gegebenenfalls eindringender Feuchtigkeit. Ferner können im unteren Rahmenelement und/oder im oberen Rahmenelement Drainagebohrungen ausgebildet sein.

Nach Maßgabe der Erfindung ist ferner die Verwendung des erfindungsgemäßen Rahmens zur Herstellung eines Solarmoduls vorgesehen. Zur Montage des Solarmoduls wird dabei wie folgt vorgegangen: Nach der Montage des unteren Rahmenelementes aus den Teilelementen wird die Abdeckung des ersten Klebebandes entfernt und das Solarelement von oben auf die erste Fläche gelegt. Die korrekte, reproduzierbare Positionierung erfolgt vorzugsweise mittels der Anschlagkante, die sicherstellt, dass das Solarelement nicht an einer falschen Position mit dem unteren Rahmenelement verklebt ist. Danach wird das fertig montierte obere Rahmenelement von oben auf den unteren Rahmen mit dem Solarelement geschoben. Vorher wurde auch hier die Abdeckung von dem zweiten Klebeband entfernt.

Die Erfindung wird nachstehend anhand von Zeichnungen näher erläutert. Dabei zeigen
- Fig. 1a: eine Schnittdarstellung eines Teilelementes des oberen Rahmenelementes eines nicht erfindungsgemäßen Rahmens;
- Fig. 1b: eine Schnittdarstellung eines Teilelementes des unteren Rahmenelementes eines nicht erfindungsgemäßen Rahmens;
- Fig. 1c: eine Schnittdarstellung des unteren und des oberen Rahmenelementes eines nicht erfindungsgemäßen Rahmens gemeinsam mit dem Solarelement nach der Montage zum Solarmodul;
- Fig. 2a: eine Schnittdarstellung eines Teilelementes des oberen Rahmenelementes gemäß einer ersten Ausführungsform des erfindungsgemäßen Rahmens;
- Fig. 2b: eine Schnittdarstellung eines Teilelementes des unteren Rahmenelementes gemäß der ersten Ausführungsform des erfindungsgemäßen Rahmens;
- Fig. 2c: eine Schnittdarstellung des unteren und des oberen Rahmenelementes gemäß der ersten Ausführungsform gemeinsam mit dem Solarelement nach der Montage zum Solarmodul;
- Fig. 3a: eine Schnittdarstellung eines Teilelementes des oberen Rahmenelementes gemäß einer zweiten Ausführungsform des erfindungsgemäßen Rahmens;
- Fig. 3b: eine Schnittdarstellung eines Teilelementes des unteren Rahmenelementes gemäß der zweiten Ausführungsform des erfindungsgemäßen Rahmens;
- Fig. 3c: eine Schnittdarstellung des unteren und des oberen Rahmenelementes gemäß der zweiten Ausführungsform gemeinsam mit dem Solarelement nach der Montage zum Solarmodul;
- Fig. 4a: eine Schnittdarstellung eines Teilelementes des oberen Rahmenelementes gemäß einer dritten Ausführungsform des erfindungsgemäßen Rahmens;
- Fig. 4b: eine Schnittdarstellung eines Teilelementes des unteren Rahmenelementes gemäß der dritten Ausführungsform des erfindungsgemäßen Rahmens;
- Fig. 4c: eine Schnittdarstellung des unteren und des oberen Rahmenelementes gemäß der dritten Ausführungsform gemeinsam mit dem Solarelement nach der Montage zum Solarmodul; und
- Fig. 5: eine Draufsicht auf das Solarmodul.

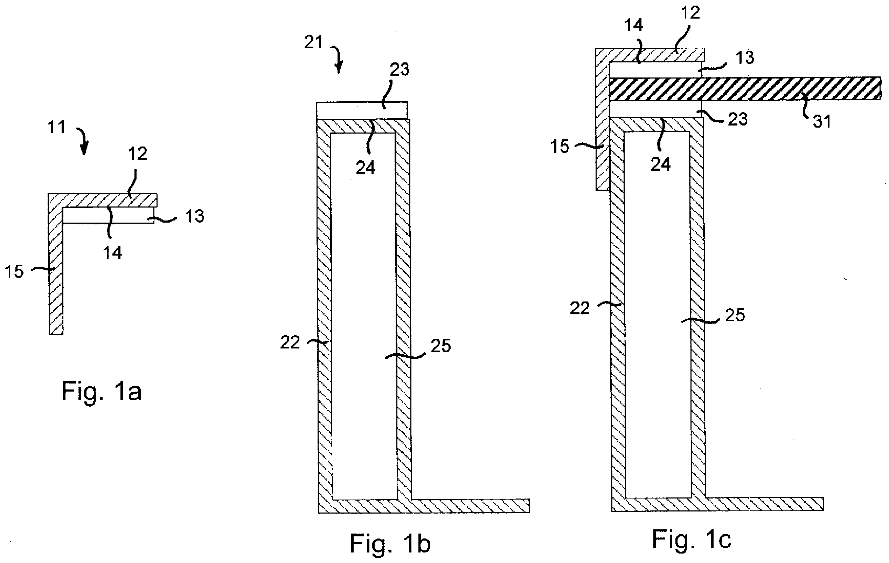

Fig. 1a zeigt das obere Rahmenelement 11 eines nicht erfindungsgemäßen Rahmens. Das obere Rahmenelement 11 weist einen winkelförmigen Querschnitt auf, wobei auf der Unterseite des ersten Schenkels 12 die zweite Fläche 14 ausgebildet ist, die mit einem Klebeband 3 ausgerüstet ist. Der zweite Schenkel 15, der an eine Stirnseite des ersten Schenkels 12 angrenzt, ist orthogonal zum ersten Schenkel 12 ausgebildet. Nach der Montage des Rahmens liegt der zweite Schenkel 15 an der Außenseite 22 des unteren Rahmenelementes 21 an.

Das untere Rahmenelement 21 (Fig. 1b) weist eine erste Fläche 24 auf, die mit einem Klebeband 23 ausgerüstet ist. Das obere Rahmenelement 21 weist ferner einen Hohlraum 25 auf, in den Eckverbinder (nicht gezeigt) formschlüssig eingesteckt werden können, um mehrere untere Rahmenelemente 21 miteinander zu verbinden.

In Fig. 1c ist der am plattenförmigen Solarelement 31 montierte Rahmen gezeigt. Es ist zu erkennen, dass die Unterseite des Solarelementes 31 in seinem Randbereich auf dem Klebeband 23, das sich auf der ersten Fläche 24 des unteren Rahmenelementes 21 befindet, aufliegt, wodurch die Unterseite des Solarmoduls 31 mit dem unteren Rahmenelement 21 verklebt ist. Das obere Rahmenelement 11 ist über das Klebeband 13, das sich auf der zweiten Fläche 14 befindet, so mit der Oberseite des Solarmodul 31 in dessen Randbereich verklebt, dass der zweite Schenkel 15 des oberen Rahmenelementes 11 an der Außenseite 22 des unteren Rahmenelementes 21 anliegt.

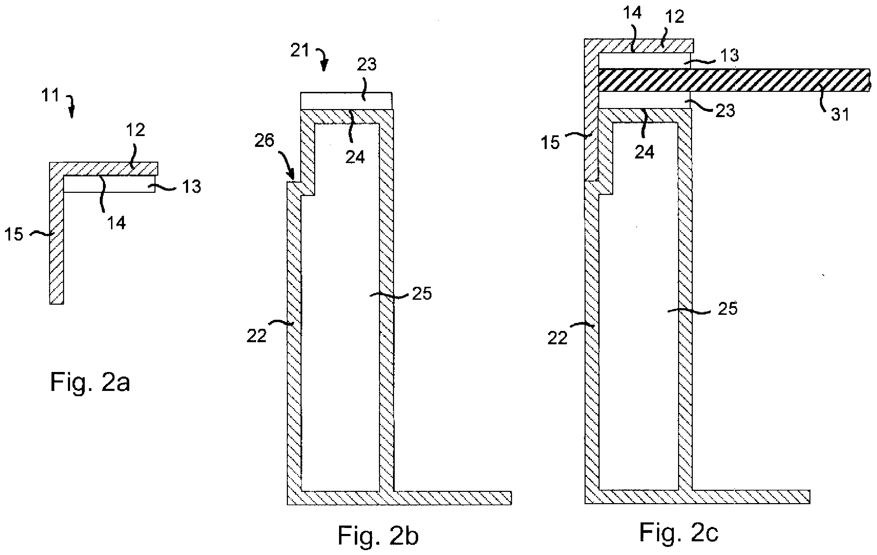

In den Fig. 2a bis 2c wird eine erste Ausführungsform des erfindungsgemäßen Rahmens gezeigt, die dem nicht erfindungsgemäßen Rahmen weitgehend gleicht. Zusätzlich ist im oberen Bereich der Außenseite 22 des unteren Rahmenelementes 21, der an die erste Fläche 24 angrenzt, eine Ausnehmung 26 vorgesehen. Die Ausnehmung 26 ist so dimensioniert, dass sie den zweiten Schenkel 15 des oberen Rahmenelementes 11 aufnehmen kann. Auf diese Weise wird eine stufenlose Außenkante des Rahmens erhalten. Die übrigen Bezugszeichen haben dieselbe Bedeutung wie in den Fig. 1a bis 1c. Dadurch, dass das untere Rahmenelement 21 die mit an der Rahmenaußenseite und Orthogonal zur ersten Fläche 24 ausgebildete Ausnehmung 26 aufweist, wird eine form- und/oder kraftschlüssige Verbindung geschaffen. Diese kraftschlüssige Verbindung kann auch durch eine Schnapp- oder Rastverbindung z. B. insofern erhalten werden, wenn an dem Rahmenelement 21 anstelle der Ausnehmung 26 eine Nut ausgebildet ist, in die ein wulstartiger Abschnitt an dem Schenkel 15 eingreift, einrastet oder einschnappt, wobei der Schenkel bevorzugterweise eine federnd-elastische Ausgestaltung aufweisen sollte.

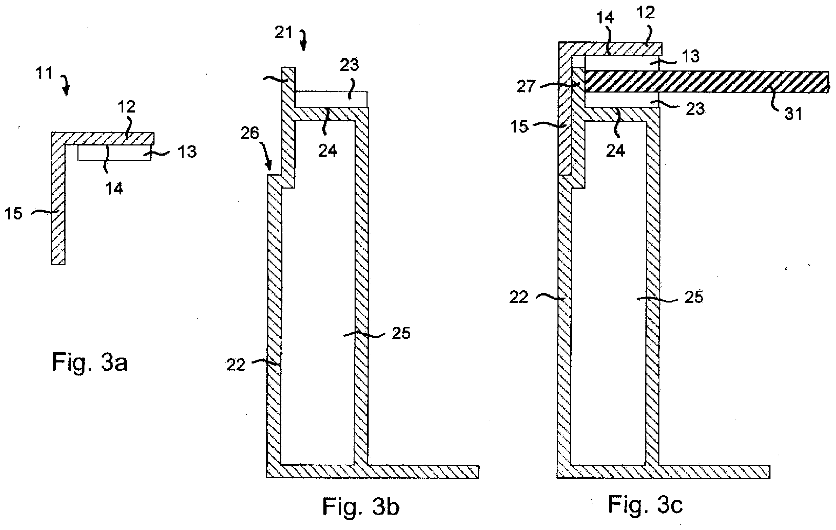

Bei der zweiten Ausführungsform des erfindungsgemäßen Rahmens, die in den Fig. 3a bis 3c gezeigt wird, ist zusätzlich zu den Merkmalen der ersten Ausführungsform (siehe Fig. 2a bis 2c) ein Steg 27 am unteren Rahmenelement 21 vorgesehen, der sich von der ersten Fläche 24 des unteren Rahmenelementes 21 in Richtung der zweiten Fläche 14 erstreckt und den Spalt, der zwischen der ersten Fläche 24 und der zweiten Fläche 14 ausgebildet ist, nach außen hin begrenzt. Der Steg 27 bildet eine Anschlagkante für das plattenförmige Solarelement 31. Die Außenseite des Steges 27 und die Außenseite 22 des unteren Rahmenelementes 21 liegen im Bereich der Ausnehmung 26 vorzugsweise in einer Ebene. Die übrigen Bezugszeichen haben dieselbe Bedeutung wie in den Fig. 2a bis 2c.

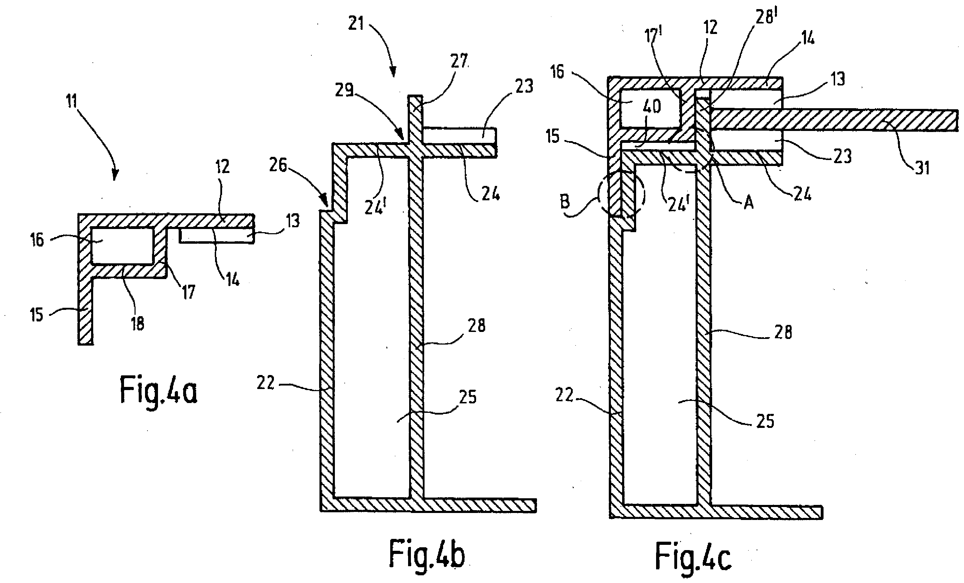

In den Fig. 4a bis 4c wird eine dritte Ausführungsform des erfindungsgemäßen Rahmens gezeigt, bei der sowohl das untere Rahmenelement 21 (wie bereits in den ersten drei Darstellungen) als auch das obere Rahmenelement 11 als Hohlprofile ausgebildet sind. Dies ermöglicht die Verbindung mehrerer oberer Rahmenelemente 11 mittels formschlüssiger Eckverbindungen (nicht gezeigt), die in die Hohlräume 16 des oberen Rahmenelementes 11 eingefügt werden. Der Hohlraum 16 wird erhalten, indem ein Steg 17 ausgebildet ist, der parallel zu dem zweiten Schenkel 15 verläuft und in Richtung der zweiten Fläche 14 von dem zweiten Schenkel 15 beabstandet ist. Der Steg 17, der kürzer als der zweite Schenkel 15 ist, beginnt an der Unterseite des ersten Schenkels 12 und mündet in einem weiteren Steg 18, der parallel zum ersten Schenkel 18 verläuft, jedoch kürzer als dieser ist. Der weitere Steg 18 beginnt an der Innenseite des Schenkels 15 und endet im Steg 17.

Abweichend von den ersten drei Darstellungen ist die Ausnehmung 26 des unteren Rahmenelementes 21 so dimensioniert, dass sie nur den Teil des zweiten Schenkels 15 aufnimmt, der sich unterhalb der Unterseite des Steges 18 befindet. Das untere Rahmenelement 21 weist ferner eine Ausnehmung 29 auf, die nach unten hin von einer Fläche 24' begrenzt wird, die auf der Seite des Steges 27 ausgebildet ist, die der ersten Fläche 24 abgewandt ist. Fläche 24 und Fläche 24' liegen bevorzugt in einer Ebene. Die Ausdehnung der Fläche 24 vom Steg 27 in Richtung der Außenseite des Rahmens entspricht dabei der Länge des Steges 18 des oberen Rahmenelementes 11. Die Länge des Steges 17 des oberen Rahmenelementes ist kleiner oder gleich der Länge des Steges 27, so dass die Ausnehmung 29 von den Kanten des oberen Rahmenelementes, die die Öffnung 18 begrenzen, ausgefüllt wird. Der Steg 27 darf die Fläche des Steges 14 nicht berühren. Das durch den Luftspalt 40 festgelegte Spaltmaß wird durch die Länge des Schenkels 15 definiert, wobei zwischen den Stegen 28' und 17' auch ein Luftspalt ausgebildet sein kann (Fig. 4c). Die Außenseiten des Stegs 27 sind in Flucht zu Innenwand 28 des unteren Rahmenelementes ausbildet. Im Bereich A kann ein Drainagekanal ausgebildet sein. Im Bereich B können Drainagebohrungen vorgesehen sein. Die übrigen Bezugszeichen haben dieselbe Bedeutung wie in den Fig. 3a bis 3c.

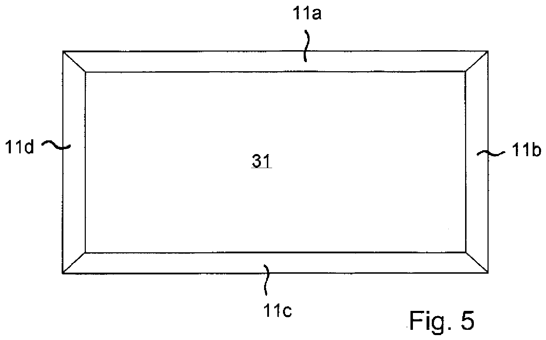

In Fig. 5 ist eine Draufsicht auf ein Solarmodul gezeigt, das einen erfindungsgemäßen Rahmen zeigt. Es ist zu erkennen, dass das obere Rahmenelement aus vier Teilelementen 11a, 11b, 11c, 11d zusammengesetzt ist. Ebenso ist das untere Rahmenelement aus vier Teilelementen (nicht gezeigt) zusammengesetzt.

### Bezuaszeichenliste

- 11: oberes Rahmenelement
- 11a, 11b, 11c, 11d: Teilelemente des oberen Rahmenelementes
- 12: erster Schenkel des oberen Rahmenelementes
- 13: zweites Klebeband
- 14: zweite Fläche des oberen Rahmenelementes
- 15: zweiter Schenkel des oberen Rahmenelementes
- 16: Hohlraum im oberen Rahmenelement
- 17: senkrechter Steg
- 18: waagegerechter Steg

- 21: unteres Rahmenelement
- 22: Außenseite des unteren Rahmenelementes
- 23: zweites Klebeband
- 24: erste Fläche des unteren Rahmenelementes
- 24': Fläche in einer Ebene mit Fläche 24
- 25: Hohlraum im unteren Rahmenelement
- 26: Ausnehmung an der Außenseite des unteren Rahmenelementes
- 27: Steg als Anschlagkante für das Solarelement 31
- 28: Innenwand
- 29: Ausnehmung oberhalb von Fläche 24'

- 31: Solarelement

## Patentansprüche

1. Rahmen für ein plattenförmiges Solarelement, umfassend ein unteres Rahmenelement (21) mit einer ersten Fläche (24) und ein oberes Rahmenelement (11) mit einer zweiten Fläche (14), wobei die zweite Fläche (14) der ersten Fläche (24) gegenüberliegt und von dieser unter Ausbildung einer Spaltes beabstandet ist, der den Randbereich des plattenförmigen Solarelementes (31) aufnehmen kann, wobei die erste Fläche und die zweite Fläche jeweils selbstklebend ausgerüstet sind, **dadurch gekennzeichnet, dass** das untere Rahmenelement (21) eine Ausnehmung (26) aufweist, die an der Rahmenaußenseite und orthogonal zur ersten Fläche (24) ausgebildet ist, und das obere Rahmenelement (11) einen Schenkel (15) aufweist, der in die Ausnehmung (26) unter Erhalt einer form- und oder kraftschlüssigen Verbindung eingeführt werden kann, wobei der Schenkel (15) orthogonal zur zweiten Fläche (14) des oberen Rahmenelementes (11) ausgebildet ist und sich von dieser in Richtung des unteren Rahmenelementes (21) erstreckt.

2. Rahmen nach Anspruch 1, **dadurch gekennzeichnet, dass** die erste Fläche (24) mit einem ersten Klebeband (23) und die zweite Fläche (14) mit einem zweiten Klebeband (13) ausgerüstet sind.

3. Rahmen nach Anspruch 2, **dadurch gekennzeichnet, dass** das erste Klebeband (23) ein doppelseitiges Klebeband ist, das eine innere Kleberschicht, die in Kontakt mit der ersten Fläche (24) steht, und eine äußere Kleberschicht aufweist, die der zweiten Fläche (14) des oberen Rahmenelementes (11) zugewandt ist.

4. Rahmen nach Anspruch 2 oder Anspruch 3, **dadurch gekennzeichnet, dass** das zweite Klebeband (13) ein doppelseitiges Klebeband ist, das eine innere Kleberschicht, die in Kontakt mit der zweiten Fläche (14) steht, und eine äußere Kleberschicht aufweist, die der ersten Fläche (24) des unteren Rahmenelementes (21) zugewandt ist.

5. Rahmen nach einem der vorstehenden Ansprüche, **dadurch gekennzeichnet, dass**, wenn das plattenförmige Solarelement (11) in den Rahmen eingelegt ist, sich die Unterseite des plattenförmiges Solarelementes (11) in dessen Randbereich in Kontakt mit der Kleberschicht des ersten Klebebandes (23) befindet und sich die Oberseite des Solarmoduls (11) in dessen Randbereich in Kontakt mit der Kleberschicht des zweiten Klebebandes (13) befindet.

6. Rahmen nach einem der vorstehenden Ansprüche, **dadurch gekennzeichnet, dass** das untere Rahmenelement (21) eine Anschlagkante (27) für das plattenförmige Solarelement aufweist, die sich von der ersten Fläche (24) in Richtung der zweiten Fläche (14) erstreckt und den Spalt, der zwischen der ersten Fläche (24) und der zweiten Fläche (14) ausgebildet ist, nach außen hin begrenzt.

7. Rahmen nach einem der vorstehenden Ansprüche, **dadurch gekennzeichnet, dass** das untere Rahmenelement (21) aus Teilelementen zusammengesetzt ist, wobei die Teilelemente Profilelemente sind, die mittels Verbindungselementen miteinander verbunden sind.

8. Rahmen nach einem der vorstehenden Ansprüche, **dadurch gekennzeichnet, dass** das obere Rahmenelement (11) aus Teilelementen (11a, 11b, 11c, 11d) zusammengesetzt ist, wobei die Teilelemente (11a, 11b, 11c, 11d) Profilelemente sind, die mittels Verbindungselementen miteinander verbunden sind.

9. Rahmen nach Anspruch 7 oder Anspruch 8, **dadurch gekennzeichnet, dass** die Teilelemente jeweils Hohlräume (16, 25) aufweisen, in die die Verbindungselemente eingeführt sind.

10. Rahmen nach einem der vorstehenden Ansprüche, **dadurch gekennzeichnet, dass** zwischen dem unteren Rahmenelement (21) und dem oberen Rahmenelement (11) eine Drainagekanal ausgebildet ist, wobei die Unterseite des Drainagekanals von einer Rille gebildet ist, die in einem Bereich der ersten Fläche (24) des unteren Rahmenelementes (21) ausgebildet ist, der nicht selbstklebend ausgerüstet ist und von der selbstklebenden Ausrüstung in Richtung der Rahmenaußenkante beabstandet ist.

11. Rahmen nach einem der vorstehenden Ansprüche, **dadurch gekennzeichnet, dass** im unteren Rahmenelement (21) und/oder im oberen Rahmenelement (11) Drainagebohrungen ausgebildet sind.

12. Verwendung eines Rahmens nach einem der Ansprüche 1 bis 11 zur Herstellung eines Solarmoduls.

13. Verwendung nach Anspruch 12, **dadurch gekennzeichnet, dass** zunächst die Unterseite des plattenförmigen Solarelementes (11) in dessen Randbereich auf die erste Fläche (24) des unteren Rahmenelementes (21) aufgelegt wird, wobei mittels des ersten Klebebandes (23) eine Klebeverbindung zwischen dem unteren Rahmenelement (21) und dem Solarelement (31) ausgebildet wird, und anschließend das obere Rahmenelement (11) derart auf die Oberseite des plattenförmigen Solarelementes (11) in dessen Randbereich aufgelegt wird, dass mittels des zweiten Klebebandes (13) eine Klebverbindung zwischen der zweiten Fläche (14) des oberen Rahmenelementes (11) und dem plattenförmigen Solarelement (31) ausgebildet wird.

## Claims

1. Frame for a plate-shaped solar element, said frame comprising a bottom frame element (21) with a first surface (24) and a top frame element (11) with a second surface (14), wherein the second surface (14) is situated opposite the first surface (24) and is at a spacing from said first surface forming a gap that can accommodate the edge region of the plate-shaped solar element (31), wherein the first surface and the second surface are each self-adhesive, **characterized in that** the bottom frame element (21) includes a recess (26) that is realized on the outside of the frame and orthogonally relative to the first surface (24), and the top frame element (11) has a portion (15) that can be introduced into the recess (26) obtaining a positive-locking and/or friction-locking connection, wherein the portion (15) is realized orthogonally relative to the second surface (14) of the top frame element (11) and extends from said second surface in the direction of the bottom frame element (21).

2. Frame according to Claim 1, **characterized in that** the first surface (24) is provided with a first adhesive strip (23) and the second surface (14) is provided with a second adhesive strip (13).

3. Frame according to Claim 2, **characterized in that** the first adhesive strip (23) is a double-sided adhesive strip that has an inside adhesive layer that is in contact with the first surface (24), and an outside adhesive layer that faces the second surface (14) of the top frame element (11).

4. Frame according to Claim 2 or Claim 3, **characterized in that** the second adhesive strip (13) is a double-sided adhesive strip that has an inside adhesive layer that is in contact with the second surface (14), and an outside adhesive layer that faces the first surface (24) of the bottom frame element (21).

5. Frame according to one of the preceding claims, **characterized in that** when the plate-shaped solar element (11) is inserted into the frame, the bottom side of the plate-shaped solar element (11) is in contact, in its edge region, with the adhesive layer of the first adhesive strip (23) and the top side of the solar module (11) is in contact, in its edge region, with the adhesive layer of the second adhesive strip (13).

6. Frame according to one of the preceding claims, **characterized in that** the bottom frame element (21) includes an abutment edge (27) for the plate-shaped solar element, said abutment edge extending from the first surface (24) in the direction of the second surface (14) and outwardly defining the gap that is realized between the first surface (24) and the second surface (14).

7. Frame according to one of the preceding claims, **characterized in that** the bottom frame element (21) is made up of part elements, wherein the part elements are profiled elements that are interconnected by means of connecting elements.

8. Frame according to one of the preceding claims, **characterized in that** the top frame element (11) is made up of part elements (11a, 11b, 11c, 11d), wherein the part elements (11a, 11b, 11c, 11d) are profiled elements that are interconnected by means of connecting elements.

9. Frame according to Claim 7 or Claim 8, **characterized in that** the part elements each have hollow spaces (16, 25) into which the connecting elements are inserted.

10. Frame according to one of the preceding claims, **characterized in that** between the bottom frame element (21) and the top frame element (11) there is a drainage channel, wherein the bottom side of the drainage channel is formed by a groove, which is realized in a region of the first surface (24) of the bottom frame element (21) that is not self-adhesive and is at a spacing from the self-adhesive finish in the direction of the outside edge of the frame.

11. Frame according to one of the preceding claims, **characterized in that** drainage bores are realized in the bottom frame element (21) and/or in the top frame element (11).

12. Use of a frame according to one of Claims 1 to 11 for producing a solar module.

13. Use according to Claim 12, **characterized in that** initially the bottom side of the plate-shaped solar element (11) is placed, in its edge region, onto the first surface (24) of the bottom frame element (21), wherein by means of the first adhesive strip (23) an adhesive connection is realized between the bottom frame element (21) and the solar element (31), and subsequently the top frame element (11) is placed in such a manner onto the top side of the plate-shaped solar element (11), in its edge region, that by means of the second adhesive strip (13) an adhesive connection is realized between the second surface (14) of the top frame element (11) and the plate-shaped solar element (31).

## Revendications

1. Cadre pour un élément solaire en forme de plaques, comprenant un élément de cadre inférieur (21) avec une première surface (24) et un élément de cadre supérieur (11) avec une deuxième surface (14), la deuxième surface (14) étant opposée à la première surface (24) et placée à une certaine distance de celle-ci par formation d'un interstice pouvant loger la zone de bordure de l'élément solaire (31) en forme de plaques, la première surface et la deuxième surface étant respectivement équipées de façon autocollante, **caractérisé en ce que** l'élément de cadre inférieur (21) comporte un évidement (26) réalisé au niveau du côté extérieur de cadre et perpendiculairement à la première surface (24) et l'élément de cadre supérieur (11) comportant une branche (15) pouvant être introduite dans l'évidement (26) en obtenant une liaison par complémentarité de formes et de forces, la branche (15) étant réalisée perpendiculairement à la deuxième surface (14) de l'élément de cadre supérieur (11) et s'étendant à partir de celui-ci en direction de l'élément de cadre inférieur (21) .

2. Cadre selon la revendication 1, **caractérisé en ce que** la première surface (24) est équipée d'un premier ruban de colle (23) et que la deuxième surface (14) est équipée d'un deuxième ruban de colle (13).

3. Cadre selon la revendication 2, **caractérisé en ce que** le premier ruban de colle (23) est un ruban de colle double face comportant une couche de colle intérieure en contact avec la première surface (24) et une couche de colle extérieure orientée vers la deuxième surface (14) de l'élément de cadre supérieur (11).

4. Cadre selon la revendication 2 ou 3, **caractérisé en ce que** le deuxième ruban de colle (13) est un ruban de colle double face comportant une couche de colle intérieure en contact avec la deuxième surface (14) et une couche de colle extérieure orientée vers la première surface (24) de l'élément de cadre inférieur (21).

5. Cadre selon l'une quelconque des revendications précédentes, **caractérisé en ce que** lorsque l'élément solaire (11) en forme de plaques est inséré dans le cadre, le côté inférieur de l'élément solaire (11) en forme de plaques se trouve dans sa zone de bordure en contact avec la couche de colle du premier ruban de colle (23) et que le côté supérieur du module solaire (11) se trouve dans sa zone de bordure en contact avec la couche de colle du deuxième ruban de colle (13).

6. Cadre selon l'une quelconque des revendications précédentes, **caractérisé en ce que** l'élément de cadre inférieur (21) comporte un bord de butée (27) pour l'élément solaire en forme de plaques s'étendant de la première surface (24) en direction de la deuxième surface (14) et délimitant l'interstice réalisé en direction de l'extérieur entre la première surface (24) et la deuxième surface (14).

7. Cadre selon l'une quelconque des revendications précédentes, **caractérisé en ce que** l'élément de cadre inférieur (21) est composé d'éléments partiels, les éléments partiels étant des éléments profilés reliés entre eux à l'aide d'éléments de liaison.

8. Cadre selon l'une quelconque des revendications précédentes, **caractérisé en ce que** l'élément de cadre supérieur (11) est composé d'éléments partiels (11a, 11b, 11c, 11d), les éléments partiels (11a, 11b, 11c, 11d) étant des éléments profilés reliés entre eux à l'aide d'éléments de liaison.

9. Cadre selon la revendication 7 ou 8, **caractérisé en ce que** les éléments partiels comportent respectivement des espaces creux (16, 25) dans lesquels les éléments de liaison sont introduits.

10. Cadre selon l'une quelconque des revendications précédentes, **caractérisé en ce qu'**un canal de drainage est réalisé entre l'élément de cadre inférieur (21) et l'élément de cadre supérieur (11), le côté inférieur du canal de drainage étant formé par une rainure réalisée dans une région de la première surface (24) de l'élément de cadre inférieur (21) et non équipée de façon autocollante et placée à une certaine distance de l'équipement autocollant en direction du bord extérieur du cadre.

11. Cadre selon l'une quelconque des revendications précédentes, **caractérisé en ce que** des alésages de drainage sont réalisés dans l'élément de cadre inférieur (21) et/ou dans l'élément de cadre supérieur (11).

12. Utilisation d'un cadre selon l'une quelconque des revendications 1 à 11 pour la fabrication d'un module solaire.

13. Utilisation selon la revendication 12, **caractérisée en ce qu'**en premier lieu, le côté inférieur de l'élément solaire (11) en forme de plaques est placé dans sa zone de bordure sur la première surface (24) de l'élément de cadre inférieur (21), une liaison collée étant réalisée entre l'élément de cadre inférieur (21) et l'élément solaire (31) à l'aide du premier ruban de colle (23) puis l'élément de cadre supérieur (11) étant placé de telle sorte sur le côté supérieur de l'élément solaire (11) en forme de plaques, dans sa zone de bordure, qu'une liaison collée est réalisée entre la deuxième surface (14) de l'élément de cadre supérieur (11) et l'élément solaire en forme de plaques (31) à l'aide du deuxième ruban de colle (13).
